# EUROPEAN PATENT SPECIFICATION

(11) **EP 2 736 173 B1**
(45) Date of publication and mention of the grant of the patent: **24.02.2021**
(21) Application number: 13194384.7
(22) Date of filing: 26.11.2013
(51) Int. Cl.: H03K 17/972, H03K 17/95, G06F 3/033, F16H 59/10, F16H 59/04, H03K 17/97

(54) **Magnetic detection type switch and shift lever device using the magnetic detection type switch**
Magnetischer Erkennungstypschalter und Schalthebelvorrichtung mit dem magnetischen Erkennungstypschalter
Commutateur de type de détection magnétique et dispositif de levier de changement de vitesse au moyen du commutateur de type de détection magnétique

(30) Priority: 27.11.2012 JP 2012258781
(43) Date of publication of application: 28.05.2014
(73) Proprietor: Alps Alpine Co., Ltd., Tokyo 145-8501 (JP)
(72) Inventor: Onodera, Takashi, Tokyo, Tokyo 145-8501 (JP); Nakamura, Tokuo, Tokyo, Tokyo 145-8501 (JP); Noguchi, Takafumi, Tokyo, Tokyo 145-8501 (JP)
(74) Representative: Schmitt-Nilson Schraud Waibel Wohlfrom Patentanwälte Partnerschaft mbB

(56) References cited:
- JP-A- 2009 014 454
- JP-A- 2009 248 917
- US-A1- 2006 261 802

## Description

The present invention relates to a magnetic detection type switch that can detect six positions with two magnetic detection units, each having four magnetoresistance effect elements, and a shift lever device using the magnetic detection type switch.

Japanese Unexamined Patent Application Publication No. 2009-204340 discloses a position detection device that includes MRE elements, bias magnets, and a shift lever (counter magnet), and detects a position of a lever based on a direction of a magnetic flux which is detected by an element when the shift lever is operated. Referring to [0030] of Japanese Unexamined Patent Application Publication No. 2009-204340, the MRE element is thought to be an AMR element.

In Japanese Unexamined Patent Application Publication No. 2009-204340, eight MRE elements (sensor chips) are arranged to detect five positions. Also, four bias magnets are arranged. According to the configuration, the multiple elements have to be arranged on a substrate to detect the five positions.

Japanese Unexamined Patent Application Publication No. 2007-333490 discloses a position detection device that includes bias magnets, and a magnetoresistance element and a shift lever (counter magnet), and detects a position of a lever based on an output result of the magnetoresistance element resulting from a change in a direction of a magnetic field generated by the counter magnet and the bias magnet when the shift lever is operated.

According to Japanese Unexamined Patent Application Publication No. 2007-333490, the plurality of bias magnets are required. Also, a Hall element is used as the magnetoresistance element.

According to US 2006/0261802 A1 a magnetic sensor includes first through fourth GMR elements. The fixed layers of the first through fourth GMR elements have respective magnetization directions toward the X-axis positive, X-axis negative, Y-axis negative, and Y-axis positive directions. When a magnet is located at the initial position, the free layers of the first through fourth GMR elements have respective magnetization directions toward the Y-axis positive, Y-axis negative, X-axis negative, and X-axis positive directions. When the magnet is located at the initial position, the magnetization axis of the magnet passes through the centroid of the first through fourth GMR elements. The magnetic sensor detects, from the resistances of these GMR elements, changes in horizontal magnetic fields of the magnet which pass through the first through fourth GMR elements and which change in accordance with the moved position of the magnet, to thereby determine the position of the magnet.

JP 2009 248917 A discloses a position detection and shifting device provided with a plurality of magnetoresistive elements which are arranged so that combination of binarized signals output from them are conform with an expansion Hamming code. The operation position detection device specifies an incorrect signal position of combination of the binarized signals based on the combination of the binarized signals output corresponding to a direction of a magnetic field acting on detection surfaces of the plurality of magnetoresistive elements and corrects the binarized signals of the specified signal position. This magnetic detection type switch has four magnetic detection units each having two sensors for the two sensitive directions, which are orthogonal. This means that there is one sensor per direction for each of the four magnetic detection units to detect in total seven different positions. This generates redundancy information, which is combined among the four magnetic detection units, which are placed at different locations.

The present invention provides a magnetic detection type switch according to independent claim 1, and a shift lever device using the magnetic detection type switch.

Preferably, the fixed magnetic layer is a self-pin stop type in which a first magnetic layer and a second magnetic layer are laminated via a non-magnetic intermediate layer, and the first magnetic layer and the second magnetic layer are magnetization-fixed in anti-parallel with each other. In this manner, the first magnetoresistance effect element and the second magnetoresistance effect element, whose sensitivity axis directions are orthogonal to each other, can be formed in an appropriate and simple manner.

Preferably, the first sensitivity axis direction is in a direction parallel with the first virtual line and the second sensitivity axis direction is in a direction parallel with the second virtual line.
Fig. 1 is a plan view of a magnetic detection type switch according to a first embodiment, which is not an embodiment of the present invention, and more particularly, an explanatory view at the time when a magnet is at a position (1);
Fig. 2 is a plan view of the magnetic detection type switch according to the first embodiment and more particularly, an explanatory view at the time when the magnet is at a position (2);
Fig. 3 is a plan view of the magnetic detection type switch according to the first embodiment, and more particularly, an explanatory view at the time when the magnet is at a position (3);
Fig. 4 is a plan view of the magnetic detection type switch according to the first embodiment, and more particularly, an explanatory view at the time when the magnet is at a position (4);
Fig. 5 is a plan view of a magnetic detection type switch according to a second embodiment, which is an embodiment of the present invention, and more particularly, an explanatory view at the time when a magnet is at a position (1);
Fig. 6 is a plan view of the magnetic detection type switch according to the second embodiment, and more particularly, an explanatory view at the time when the magnet is at a position (2);
Fig. 7 is a plan view of the magnetic detection type switch according to the second embodiment, and more particularly, an explanatory view at the time when the magnet is at a position (3);
Fig. 8 is a plan view of the magnetic detection type switch according to the second embodiment, and more particularly, an explanatory view at the time when the magnet is at a position (4);
Fig. 9 is a plan view of the magnetic detection type switch according to the second embodiment, and more particularly, an explanatory view at the time when the magnet is at a position (5);
Fig. 10 is a plan view (conceptual view) of a magnetic detection type switch according to a third embodiment, which is not an embodiment of the present invention;
Fig. 11 is a partial longitudinal sectional view showing an element structure of a magnetoresistance effect element according to an embodiment of the present invention;
Fig. 12 is a perspective view of a magnetic detection unit;
Fig. 13 is a partial plan view of a first magnetoresistance effect element;
Fig. 14 is a circuit view of a switch circuit constituting a first detection unit and a second detection unit;
Fig. 15 is an output waveform chart of the switch circuit; and
Fig. 16 is a perspective view showing a shift lever device of the embodiments of the present invention.

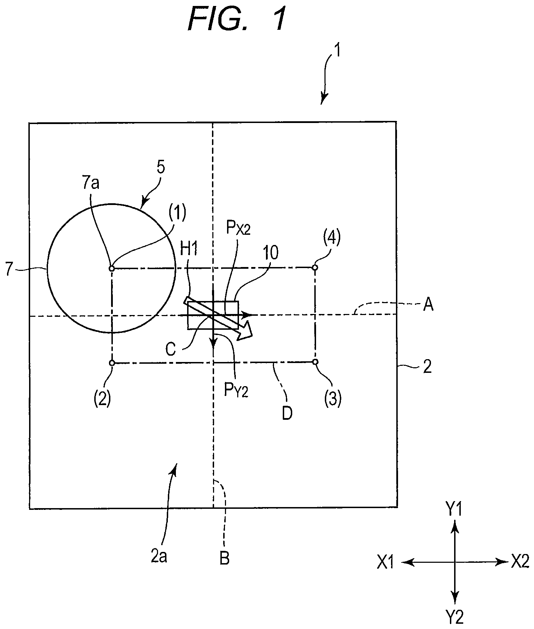

A magnetic detection type switch 1 shown in Fig. 1, which is not an embodiment of the present invention, is configured to include one magnet (magnetic field generation unit) 7, and one magnetic detection unit 10. The magnet 7 and the magnetic detection unit 10 are arranged not to be in contact with each other.

As shown in Fig. 1, the magnet 7 has, for example, a circular shape when seen in a plan view, but the shape is not limited thereto. The magnet 7 has a predetermined thickness, and has an upper surface and a lower surface magnetized to different poles.

The magnet 7 shown in Fig. 1 is disposed in a movable portion 5, and the magnetic detection unit 10 is disposed in a fixed portion 2 (substrate).

As shown in Fig. 1, a surface 2a of the fixed portion 2 is divided into four positions (1) to (4) by one first virtual line A and one second virtual line B that are orthogonal to each other in a plane. As shown in Fig. 1, the first virtual line A extends in parallel with an X1-X2 direction, and the second virtual line B extends in parallel with a Y1-Y2 direction.

The positions (1) to (4) refer to detection positions of the magnet 7 and, in Fig. 1, refer to four positions at which the center 7a of the magnet 7 are farthest away from a crossing position C where the first virtual line A and the second virtual line B cross each other in an area in which the magnet 7 is movable. For example, the center 7a of the magnet 7 is supported to be movable along a pattern D shown with the one-dot chain line.

The (center of the) magnetic detection unit 10 is disposed at the crossing position C of the first virtual line A and the second virtual line B.

The magnetic detection unit 10 has first magnetoresistance effect elements and second magnetoresistance effect elements.

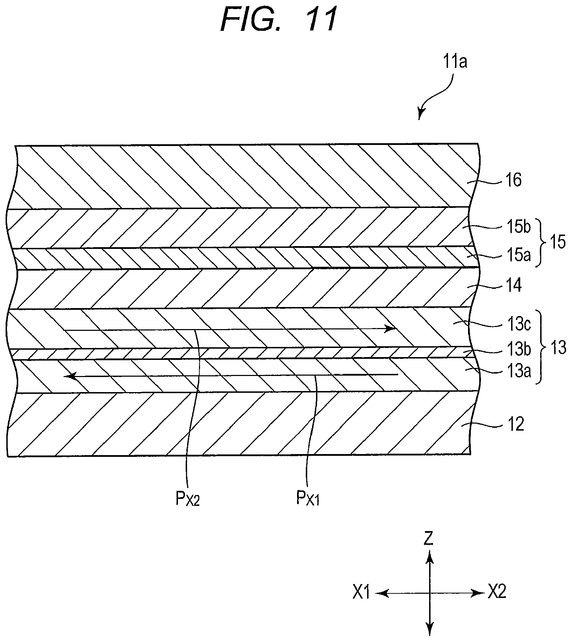

Fig. 11 shows a laminated structure of element portions 11a that constitute the first magnetoresistance effect elements (GMR elements) 11. As shown in Fig. 11, the first magnetoresistance effect element 11 is laminated and deposited in the order of a seed layer 12, a fixed magnetic layer 13, a non-magnetic material layer 14, a free magnetic layer 15, and a protective layer 16 from below. Each of the layers that constitute the first magnetoresistance effect element 11 is deposited by, for example, sputtering.

The seed layer 12 is formed of NiFeCr, Cr, or the like. The film thickness of the seed layer 12 is approximately between 36 and 60 Angstroms. A ground layer that is formed of Ta, Hf, Nb, Zr, Ti, Mo, W, or the like may be formed between the seed layer 12 and the substrate.

The fixed magnetic layer 13 is a synthetic ferri pin (SFP) structure that has a first magnetic layer 13a, a second magnetic layer 13c, and a non-magnetic intermediate layer 13b which is interposed between the first magnetic layer 13a and the second magnetic layer 13c.

As shown in Fig. 1, a fixed magnetization direction (P_{X1}) of the first magnetic layer 13a and a fixed magnetization direction (P_{X2}) of the second magnetic layer 13c are anti-parallel with each other.

As shown in Fig. 1, the first magnetic layer 13a is formed on the seed layer 12, and the second magnetic layer 13c is formed to be in contact with the non-magnetic material layer 14 that will be described later.

The fixed magnetic layer 13 according to the embodiment is a self-pin stop type that has the SFP structure, that is, a structure that has no anti-ferromagnetic layer, but the laminated structure of the fixed magnetic layer 13, the non-magnetic material layer 14, and the free magnetic layer 15 is provided even in this case.

The fixed magnetic layer 13 and the free magnetic layer 15 are formed of a soft magnetic material such as NiFe and CoFe, and CoFeNi. The non-magnetic material layer 14 is formed of a non-magnetic conductive material such as Cu and an insulating layer of Al₂O₃ or the like. The free magnetic layer 15 is a two-layered structure that has the sign 15a and the sign 15b. For example, the sign 15a is formed of CoFe and the sign 15b is formed of NiFe. The free magnetic layer 15 may be a single-layered structure.

What is important to increase the magnetization fixation force of the fixed magnetic layer 13 is to increase the coercive force Hc of the first magnetic layer 13a, to adjust the difference between the amount of magnetization of the first magnetic layer 13a and the amount of magnetization of the second magnetic layer 13c to substantially zero, and, furthermore, to strengthen an anti-parallel coupling magnetic field by adjusting the film thickness of the non-magnetic intermediate layer 13b and using an RKKY interaction which is generated between the first magnetic layer 13a and the second magnetic layer 13c.

The sensitivity axis direction of the first magnetoresistance effect element 11 is the fixed magnetization direction P_{X2} of the second magnetic layer 13c that constitutes the fixed magnetic layer 13 which is shown in Fig. 11.

An element portion that constitutes the second magnetoresistance effect element is a laminated structure as in Fig. 11, but, as shown in Fig. 1, the sensitivity axis direction P_{Y2} is orthogonal to the first sensitivity axis direction P_{X2} of the first magnetoresistance effect element 11.

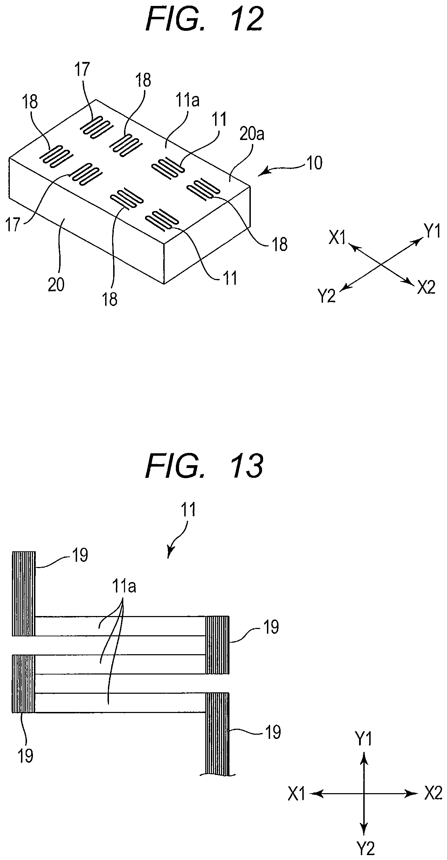

As shown in Fig. 12, in the magnetic detection unit 10, the pair of first magnetoresistance effect elements 11, the pair of second magnetoresistance effect elements 17, and four fixed resistance elements 18 are mounted on an upper surface 20a of an IC package 20 through a thin film formation process.

As shown in Fig. 13, the first magnetoresistance effect element 11 is configured to have the plurality of element portions 11a that are formed to be elongate in the X1-X2 direction with gaps in the Y1-Y2 direction, and conductive connecting units 19 which connect end portions of the adjacent element portions 11a with each other. The first magnetoresistance effect element 11 has a meandering shape because of the element portions 11a and the connecting units 19.

The second magnetoresistance effect element 17 is formed to have a meandering shape as is the case with the first magnetoresistance effect element 11. However, the shape of the second magnetoresistance effect element 17 is the meandering shape of Fig. 13 rotated by 90 degrees.

With the self-pin stop type magnetoresistance effect element shown in Fig. 11, both of the first magnetoresistance effect element 11 and the second magnetoresistance effect element 17 can be formed on the same substrate. However, if the first sensitivity axis direction P_{X2} of the first magnetoresistance effect element 11 and the second sensitivity axis direction P_{Y2} of the second magnetoresistance effect element 17 can be orthogonal to each other, a type other than the self-pin stop type may be used. For example, the magnetization direction (sensitivity direction) of the fixed magnetic layer can be fixed in a predetermined direction through a heat treatment in a magnetic field using an anti-ferromagnetic layer with different substrates being used.

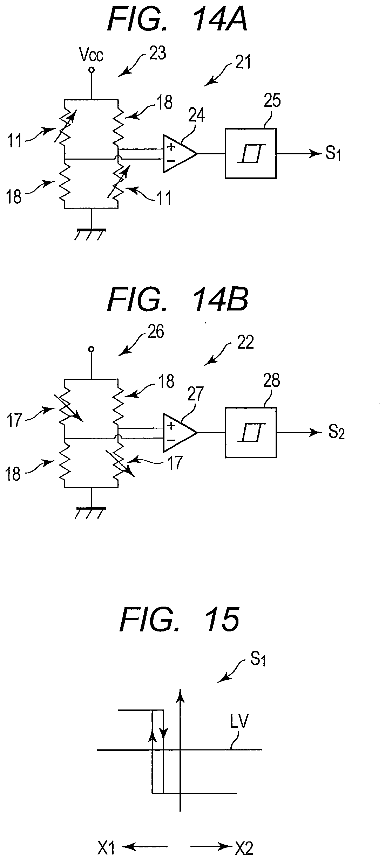

As shown in Fig. 14A, a first switch circuit 21 is configured to have a bridge circuit 23 that has the two first magnetoresistance effect elements 11 and the two fixed resistance elements 18. Two midpoint potentials between the first magnetoresistance effect elements 11 and the fixed resistance elements 18 are given to a differential amplifier 24 and a differential output is obtained. The differential output is given to a schmitt trigger circuit 25.

As shown in Fig. 14B, a second switch circuit 22 is configured to have a bridge circuit 26 that has the two second magnetoresistance effect elements 17 and the two fixed resistance elements 18. Two midpoint potentials between the second magnetoresistance effect elements 17 and the fixed resistance elements 18 are given to a differential amplifier 27 and a differential output is obtained. The differential output is given to a schmitt trigger circuit 28.

When an external magnetic field H reaches in the X2 direction with respect to the element portion 11a of the first magnetoresistance effect element 11 shown in Fig. 11, the magnetization direction of the free magnetic layer 15 is in the X2 direction and the magnetization directions of the free magnetic layer 15 and the fixed magnetic layer 13 are in parallel with each other, and an electrical resistance value (voltage value at both ends of the element) is decreased as shown in Fig. 15. When the external magnetic field H reaches in the X1 direction with respect to the element portion 11a of the first magnetoresistance effect element 11, the magnetization direction of the free magnetic layer 15 is in the X1 direction and the magnetization directions of the free magnetic layer 15 and the fixed magnetic layer 13 are in anti-parallel with each other, and the electrical resistance value (voltage value at both of the ends of the element) is increased as shown in Fig. 15.

As shown in Fig. 15, a threshold LV is determined in the schmitt trigger circuit 25 and, for example, an ON signal and an OFF signal are output as a first detection output S1 when the electrical resistance value is below the threshold LV and when the electrical resistance value is above the threshold LV, respectively.

When the external magnetic field H reaches in the Y1 direction with respect to the second magnetoresistance effect element 17, the magnetization direction of the free magnetic layer 15 is in the Y1 direction and the magnetization directions (Y2 direction) of the free magnetic layer 15 and the fixed magnetic layer 13 are in anti-parallel with each other, and an electrical value is increased. When the external magnetic field H reaches in the Y2 direction with respect to the second magnetoresistance effect element 17, the magnetization direction of the free magnetic layer 15 is in the Y2 direction and the magnetization directions of the free magnetic layer 15 and the fixed magnetic layer 13 are in parallel with each other, and the electrical value is decreased.

As in Fig. 15, the threshold LV is determined in the schmitt trigger circuit and, for example, an ON signal and an OFF signal are output as a second detection output S2 when the electrical resistance value is below the threshold LV and when the electrical resistance value is above the threshold LV, respectively.

Fig. 15 shows a hysteresis loop as an example. The hysteresis loop can be made different by the magnitude of an inter-layer coupling magnetic field Hin or the like. In this case, the shape of the hysteresis loop is not particularly limited if the ON signal and the OFF signal can be switched by the difference in the direction of the external magnetic field.

When the magnet 7 is present at the first position (1) as shown in Fig. 1, a first external magnetic field H1 is applied to the magnetic detection unit 10 from the magnet 7. As shown in Fig. 1, the direction of the first external magnetic field H1 is inclined obliquely with respect to the X2 direction and the Y2 direction.

When the magnetic detection unit 10 receives the first external magnetic field H1, the magnetization directions of the free magnetic layers 15 of both of the first magnetoresistance effect element 11 and the second magnetoresistance effect element 17 are in the direction of the first external magnetic field H1.

In this manner, in the first magnetoresistance effect element 11, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output S1 with the ON signal is output.

Also, in the second magnetoresistance effect element 17, the magnetization direction of the free magnetic layer 15 approaches the second sensitivity axis direction P_{Y2}, and thus the electrical resistance value of the first magnetoresistance effect element 11 is decreased. In this case, the electrical resistance value is below the threshold LV, and the second detection output S2 with the ON signal is output.

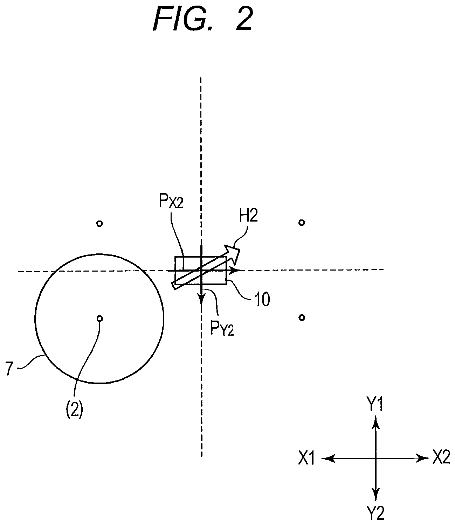

Next, when the magnet 7 is present at the second position (2) as shown in Fig. 2, a second external magnetic field H2 is applied to the magnetic detection unit 10 from the magnet 7. As shown in Fig. 2, the direction of the second external magnetic field H2 is inclined obliquely with respect to the X2 direction and the Y1 direction.

When the magnetic detection unit 10 receives the second external magnetic field H2, the magnetization directions of the free magnetic layers 15 of both of the first magnetoresistance effect element 11 and the second magnetoresistance effect element 17 are in the direction of the second external magnetic field H2.

In this manner, in the first magnetoresistance effect element 11, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output S1 with the ON signal is output.

Also, in the second magnetoresistance effect element 17, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output S2 with the OFF signal is output.

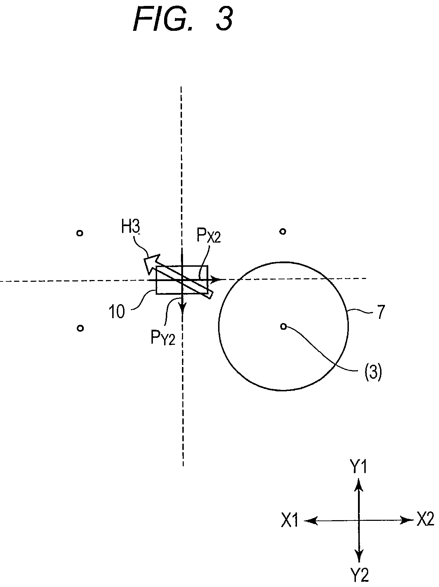

Next, when the magnet 7 is present at the third position (3) as shown in Fig. 3, a third external magnetic field H3 is applied to the magnetic detection unit 10 from the magnet 7. As shown in Fig. 3, the direction of the third external magnetic field H3 is inclined obliquely with respect to the X1 direction and the Y1 direction.

When the magnetic detection unit 10 receives the third external magnetic field H3, the magnetization directions of the free magnetic layers 15 of both of the first magnetoresistance effect element 11 and the second magnetoresistance effect element 17 are in the direction of the third external magnetic field H3.

In this manner, in the first magnetoresistance effect element 11, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output S1 with the OFF signal is output.

Also, in the second magnetoresistance effect element 17, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output S2 with the OFF signal is output.

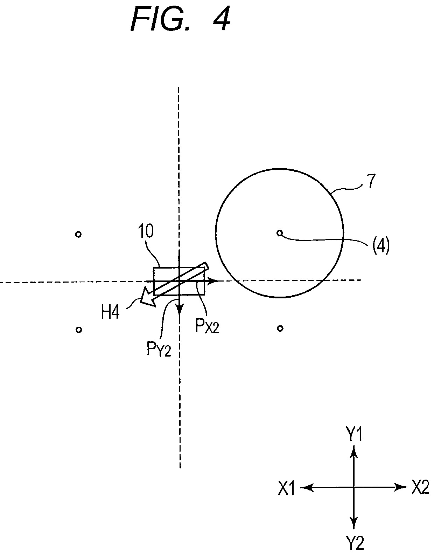

Next, when the magnet 7 is present at the fourth position (4) as shown in Fig. 4, a fourth external magnetic field H4 is applied to the magnetic detection unit 10 from the magnet 7. As shown in Fig. 4, the direction of the fourth external magnetic field H4 is inclined obliquely with respect to the X1 direction and the Y2 direction.

When the magnetic detection unit 10 receives the fourth external magnetic field H4, the magnetization directions of the free magnetic layers 15 of both of the first magnetoresistance effect element 11 and the second magnetoresistance effect element 17 are in the direction of the fourth external magnetic field H4.

In this manner, in the first magnetoresistance effect element 11, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output S1 with the OFF signal is output.

In the second magnetoresistance effect element 17, the magnetization direction of the free magnetic layer 15 approaches the second sensitivity axis direction P_{Y2}, and thus the electrical resistance value of the second magnetoresistance effect element 17 is decreased. In this case, the electrical resistance value is below the threshold LV, and the second detection output S2 with the ON signal is output.

The following Table 1 shows the relationship between each of the above-described positions (1) to (4) and the first detection output S1 and the second detection output S2.

**[Table 1]**

| Position | S1 | S2 |
|---|---|---|
| (1) | ON | ON |
| (2) | ON | OFF |
| (3) | OFF | OFF |
| (4) | OFF | ON |

As shown in Table 1, the combinations of the ON signal and the OFF signal of the first detection output S1 and the second detection output S2 are different from each other (do not match each other) at each of the positions (1) to (4). Accordingly, the four positions (1) to (4) can be detected by the ON signal and the OFF signal obtained from the first detection output S1 and the second detection output S2.

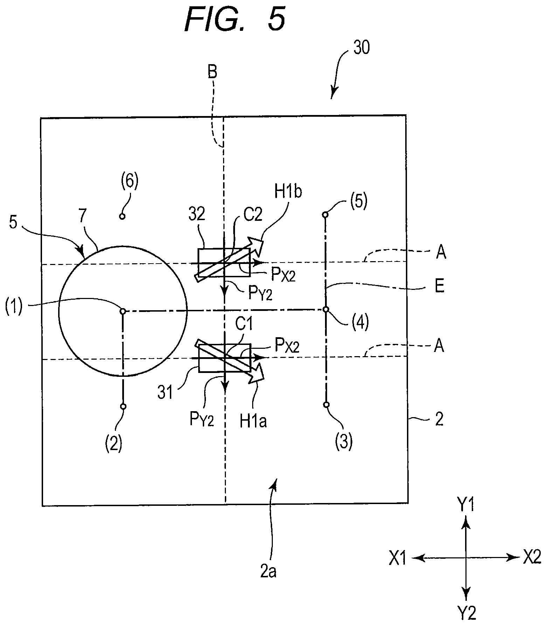

Figs. 5 to 9 show a magnetic detection type switch 30 according to a second embodiment. The same reference numerals are attached to the same parts as in Fig. 1.

As shown in Fig. 5, the magnetic detection type switch 30 is configured to include the one magnet (magnetic field generation unit) 7, and two magnetic detection units 31 and 32. The magnet 7 and each of the magnetic detection units 31 and 32 are arranged not to be in contact with each other.
The magnet 7 shown in Fig. 5 is disposed in the movable portion 5, and each of the magnetic detection units 31 and 32 is disposed in the fixed portion 2 (substrate).

As shown in Fig. 5, the surface 2a of the fixed portion 2 is divided into six positions (1) to (6) by two first virtual lines A and one second virtual line B that are orthogonal to each other in a plane. The first virtual lines A are disposed with a gap in the Y1-Y2 direction, which is the direction of the second virtual line B.

The (centers of the) magnetic detection units 31 and 32 are respectively disposed at crossing positions C1 and C2 where the respective first virtual lines A cross the second virtual line B.

As is the case with the magnetic detection unit 10 shown in Fig. 1, the first magnetic detection unit 31 and the second magnetic detection unit 32 have the first magnetoresistance effect element 11 and the second magnetoresistance effect element 17 shown in Fig. 12, and a plane pattern of each of the magnetoresistance effect elements 11 and 17, a laminated configuration of the element portion, and a configuration of the switch circuit are as shown in Figs. 11 to 15.

The magnet 7 is supported to be movable along the one-dot chain line E by the movable portion 5.

As shown in Fig. 5, when the magnet 7 is at the first position (1), first external magnetic fields H1a and H1b are applied to the first magnetic detection unit 31 and the second magnetic detection unit 32, respectively.

In this case, the direction of the first external magnetic field H1a that is applied to the first magnetic detection unit 31 is inclined obliquely with respect to the X2 direction and the Y2 direction.

When the first magnetic detection unit 31 receives the first external magnetic field H1a, the magnetization directions of the free magnetic layers 15 of both of the first magnetoresistance effect element 11 and the second magnetoresistance effect element 17 are in the direction of the first external magnetic field H1a.

In this manner, in the first magnetoresistance effect element 11 that constitutes the first magnetic detection unit 31, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output S1 with the ON signal is output. Hereinafter, the first detection output from the first magnetic detection unit 31 is referred to as a "first detection output (1-S1)."

Also, in the second magnetoresistance effect element 17 that constitutes the first magnetic detection unit 31, the magnetization direction of the free magnetic layer 15 approaches the second sensitivity axis direction P_{Y2}, and thus the electrical resistance value of the second magnetoresistance effect element 17 is decreased. In this case, the electrical resistance value is below the threshold LV, and the second detection output S2 with the ON signal is output. Hereinafter, the second detection output from the first magnetic detection unit 31 is referred to as a "second detection output (1-S2)."

The direction of the first external magnetic field H1b that is applied to the second magnetic detection unit 32 is inclined obliquely with respect to the X2 direction and the Y1 direction.

When the second magnetic detection unit 32 receives the first external magnetic field H1b, the magnetization directions of the free magnetic layers 15 of both of the first magnetoresistance effect element 11 and the second magnetoresistance effect element 17 are in the direction of the first external magnetic field H1b.

In this manner, in the first magnetoresistance effect element 11 of the second magnetic detection unit 32, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output S1 with the ON signal is output. Hereinafter, the first detection output from the second magnetic detection unit 32 is referred to as a "first detection output (2-S1)."

Also, in the second magnetoresistance effect element 17 of the second magnetic detection unit 32, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output S2 with the OFF signal is output. Hereinafter, the second detection output from the second magnetic detection unit 32 is referred to as a "second detection output (2-S2)."

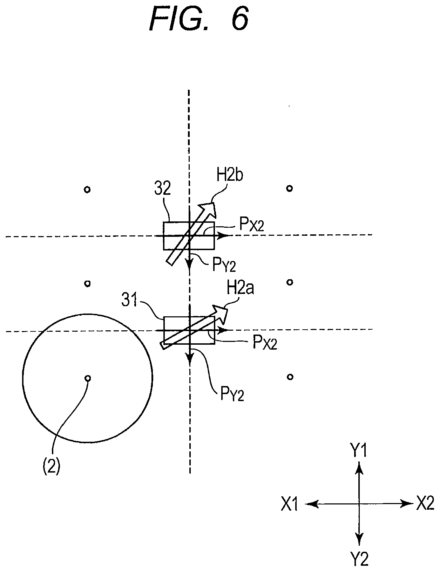

Next, when the magnet 7 is present at the second position (2) as shown in Fig. 6, second external magnetic fields H2a and H2b are applied from the magnet 7 to the magnetic detection units 31 and 32, respectively.

In this case, the direction of the second external magnetic field H2a that is applied to the first magnetic detection unit 31 is inclined obliquely with respect to the X2 direction and the Y1 direction.

When the first magnetic detection unit 31 receives the second external magnetic field H2a, the magnetization directions of the free magnetic layers 15 of both of the first magnetoresistance effect element 11 and the second magnetoresistance effect element 17 constituting the first magnetic detection unit 31 are in the direction of the second external magnetic field H2a.

In this manner, in the first magnetoresistance effect element 11 that constitutes the first magnetic detection unit 31, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output (1-S1) with the ON signal is output.

Also, in the second magnetoresistance effect element 17 that constitutes the first magnetic detection unit 31, the magnetization direction of the free magnetic layer 15 is away from the second sensitivity axis direction P_{Y2}, and thus the electrical resistance value of the second magnetoresistance effect element 17 is increased.

In this case, the electrical resistance value is above the threshold LV, and the second detection output (1-S2) with the OFF signal is output.

The direction of the second external magnetic field H2b that is applied to the second magnetic detection unit 32 is inclined obliquely with respect to the X2 direction and the Y1 direction.

When the second magnetic detection unit 32 receives the second external magnetic field H2b, the magnetization directions of the free magnetic layers 15 of both of the first magnetoresistance effect element 11 and the second magnetoresistance effect element 17 are in the direction of the second external magnetic field H2b.

In this manner, in the first magnetoresistance effect element 11 of the second magnetic detection unit 32, the magnetization direction of the free magnetic layer 15 approaches the first sensitivity axis direction P_{X2}, and thus the electrical resistance value of the first magnetoresistance effect element 11 is decreased. In this case, the electrical resistance value is below the threshold LV, and the first detection output (2-S1) with the ON signal is output.

In the second magnetoresistance effect element 17 of the second magnetic detection unit 32, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output (2-S2) with the OFF signal is output.

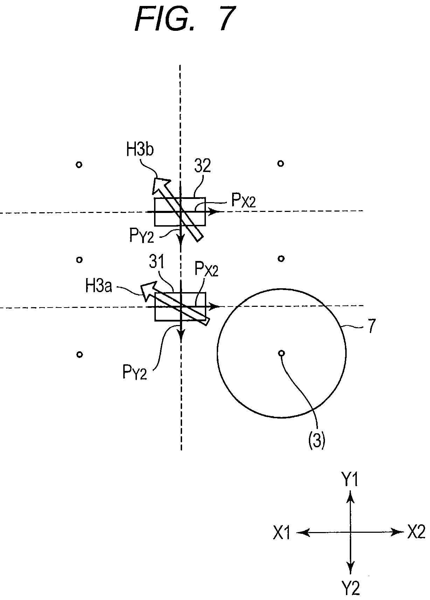

Next, when the magnet 7 is present at the third position (3) as shown in Fig. 7, third external magnetic fields H3a and H3b are applied from the magnet 7 to the magnetic detection units 31 and 32, respectively.

In this case, as shown in Fig. 7, the direction of the third external magnetic field H3a that is applied to the first magnetic detection unit 31 is inclined obliquely with respect to the X1 direction and the Y1 direction.

When the first magnetic detection unit 31 receives the third external magnetic field H3a, the magnetization directions of the free magnetic layers 15 of both of the first magnetoresistance effect element 11 and the second magnetoresistance effect element 17 are in the direction of the third external magnetic field H3a.

In this manner, in the first magnetoresistance effect element 11 that constitutes the first magnetic detection unit 31, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (1-S1) with the OFF signal is output.

Also, in the second magnetoresistance effect element 17 that constitutes the first magnetic detection unit 31, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output (1-S2) with the OFF signal is output.

Also, the direction of the third external magnetic field H3b that is applied to the second magnetic detection unit 32 is inclined obliquely with respect to the X1 direction and the Y1 direction.

When the second magnetic detection unit 32 receives the third external magnetic field H3b, the magnetization directions of the free magnetic layers 15 of both of the first magnetoresistance effect element 11 and the second magnetoresistance effect element 17 are in the direction of the third external magnetic field H3b.

In this manner, in the first magnetoresistance effect element 11 of the second magnetic detection unit 32, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (2-S1) with the OFF signal is output.

Also, in the second magnetoresistance effect element 17 of the second magnetic detection unit 32, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output (2-S2) with the OFF signal is output.

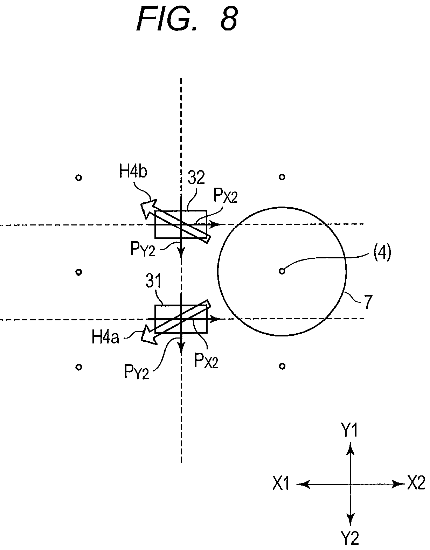

Next, when the magnet 7 is present at the fourth position (4) as shown in Fig. 8, fourth external magnetic fields H4a and H4b are applied from the magnet 7 to the magnetic detection units 31 and 32, respectively.

In this case, as shown in Fig. 8, the direction of the fourth external magnetic field H4a that is applied to the first magnetic detection unit 31 is inclined obliquely with respect to the X1 direction and the Y2 direction.

When the first magnetic detection unit 31 receives the fourth external magnetic field H4a, the magnetization directions of the free magnetic layers 15 of both of the first magnetoresistance effect element 11 and the second magnetoresistance effect element 17 are in the direction of the fourth external magnetic field H4a.

In this manner, in the first magnetoresistance effect element 11 that constitutes the first magnetic detection unit 31, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (1-S1) with the OFF signal is output.

in the second magnetoresistance effect element 17 that constitutes the first magnetic detection unit 31, the magnetization direction of the free magnetic layer 15 approaches the second sensitivity axis direction P_{Y2}, and thus the electrical resistance value of the second magnetoresistance effect element 17 is decreased. In this case, the electrical resistance value is below the threshold LV, and the second detection output (1-S2) with the ON signal is output.

Also, the direction of the fourth external magnetic field H4b that is applied to the second magnetic detection unit 32 is inclined obliquely with respect to the X1 direction and the Y1 direction.

When the second magnetic detection unit 32 receives the fourth external magnetic field H4b, the magnetization directions of the free magnetic layers 15 of both of the first magnetoresistance effect element 11 and the second magnetoresistance effect element 17 are in the direction of the fourth external magnetic field H4b.

In this manner, in the first magnetoresistance effect element 11 of the second magnetic detection unit 32, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (2-S1) with the OFF signal is output.

Also, in the second magnetoresistance effect element 17 of the second magnetic detection unit 32, the magnetization direction of the free magnetic layer 15 is away from the second sensitivity axis direction P_{Y2}, and thus the electrical resistance value of the second magnetoresistance effect element 17 is increased. In this case, the electrical resistance value is above the threshold LV, and the second detection output (2-S2) with the OFF signal is output.

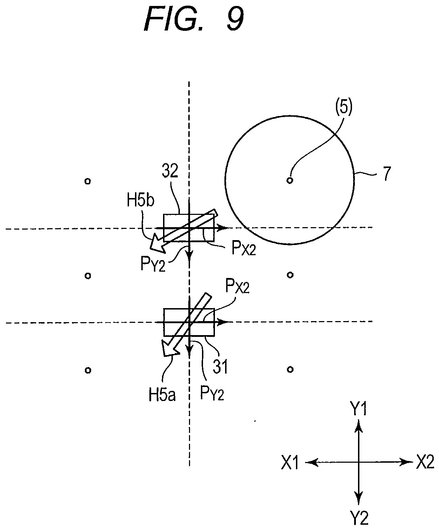

Next, when the magnet 7 is present at the fifth position (5) as shown in Fig. 9, fifth external magnetic fields H5a and H5b are applied from the magnet 7 to the magnetic detection units 31 and 32, respectively.
In this case, as shown in Fig. 9, the direction of the fifth external magnetic field H5a that is applied to the first magnetic detection unit 31 is inclined obliquely with respect to the X1 direction and the Y2 direction.

When the first magnetic detection unit 31 receives the fifth external magnetic field H5a, the magnetization directions of the free magnetic layers 15 of both of the first magnetoresistance effect element 11 and the second magnetoresistance effect element 17 are in the direction of the fifth external magnetic field H5a.

In this manner, in the first magnetoresistance effect element 11 that constitutes the first magnetic detection unit 31, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (1-S1) with the OFF signal is output.

In the second magnetoresistance effect element 17 that constitutes the first magnetic detection unit 31, the magnetization direction of the free magnetic layer 15 approaches the second sensitivity axis direction P_{Y2}, and thus the electrical resistance value of the second magnetoresistance effect element 17 is decreased. In this case, the electrical resistance value is below the threshold LV, and the second detection output (1-S2) with the ON signal is output.

Also, the direction of the fifth external magnetic field H5b that is applied to the second magnetic detection unit 32 is inclined obliquely with respect to the X1 direction and the Y2 direction.

When the second magnetic detection unit 32 receives the fifth external magnetic field H5b, the magnetization directions of the free magnetic layers 15 of both of the first magnetoresistance effect element 11 and the second magnetoresistance effect element 17 are in the direction of the fifth external magnetic field H5b.

In this manner, in the first magnetoresistance effect element 11 of the second magnetic detection unit 32, the magnetization direction of the free magnetic layer 15 is away from the first sensitivity axis direction P_{X2}, and thus the electrical resistance value of the first magnetoresistance effect element 11 is increased. In this case, the electrical resistance value is above the threshold LV, and the first detection output (2-51) with the OFF signal is output.

Also, in the second magnetoresistance effect element 17 of the second magnetic detection unit 32, the magnetization direction of the free magnetic layer 15 approaches the second sensitivity axis direction P_{Y2}, and thus the electrical resistance value of the second magnetoresistance effect element 17 is decreased. In this case, the electrical resistance value is below the threshold LV, and the second detection output (2-S2) with the ON signal is output.

The following Table 2 shows the relationship between each of the above-described positions (1) to (5) and each of the detection outputs (1-S1), (2-S1), (1-S2), and (2-52).

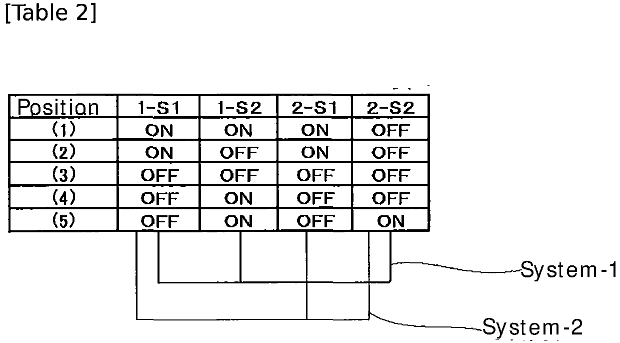

As shown in Table 2, the combinations of the ON signal and the OFF signal of the detection outputs (1-S1), (2-S1), (1-S2), and (2-S2) are different from each other (do not match each other) at each of the positions (1) to (5). Accordingly, the five positions (1) to (5) can be detected by the ON signal and the OFF signal obtained from the detection outputs (1-S1), (2-S1), (1-S2), and (2-S2).

Also, the five positions (1) to (5) can be detected from the combinations of the ON signal and the OFF signal of both of the first magnetic detection unit 31 and the second magnetic detection unit 32 to add fault detection redundancy. For example, as shown in Table 2, a system-1 that combines the detection outputs (1-S1), (1-S2), (2-S2), and a system-2 that combines the detection outputs (2-S1), (1-S2), and (2-S2), and the like are made. In this case, the five positions (1) to (5) can be detected by activating the system-1 even if, for example, the first detection output (2-S1) of the second magnetic detection unit 32 is out of order for any reason to cause output malfunctioning. Any decision can be made as to what systems are to be made. For example, as described above, both of the detection outputs of one magnetic detection unit and one detection output of the other magnetic detection unit can be combined.

In the embodiment shown in Figs. 5 to 9, the magnet 7 (movable portion 5) moves from the positions (1) to (5), but does not move to the sixth position (6), and thus the sixth position (6) does not necessarily have to be detected. However, the magnetic detection type switch 30 shown in Figs. 5 to 9 also can detect the sixth position (6) (refer to Fig. 5), and thus can detect five or more positions.

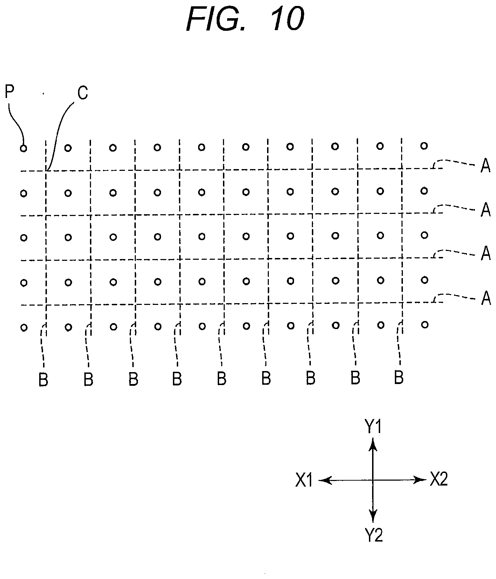

A third embodiment, which shown in Fig. 10 but not part of the claimed invention, is divided into multiple positions P (circles shown in Fig. 10) by a plurality of first virtual lines A and a plurality of second virtual lines B, and a plurality of magnetic detection units are arranged at crossing positions C where the first virtual lines A and the second virtual lines B cross each other so that all of the positions P to which the movable portion (magnet 7) can move can be detected. In Fig. 10, the reference numerals are attached to only one of the positions P and one of the crossing positions C.

In the embodiment shown in Fig. 10, the magnetic detection units may be arranged at only some of the crossing positions C. In other words, if the movable portion (magnet 7) does not move to some of the positions P, such positions P may not be detected, and the plurality of magnetic detection units may be arranged at the positions P that are to be detected. For example, the magnetic detection units can be arranged at every other crossing position C.

Also, the magnetic detection units can be arranged at all of the crossing positions C. In this case, all of the positions P can be detected from a combination of detection outputs from two or more of the magnetic detection units, and fault detection redundancy can be added.

According to the above-described embodiment, the magnet 7 is arranged in the movable portion 5 and the magnetic detection unit is arranged in the fixed portion 2. However, the magnet may be installed on the fixed portion side and the magnetic detection unit may be disposed on the movable portion side.

The first sensitivity axis direction P_{X2} of the first magnetoresistance effect element 11 and the second sensitivity axis direction P_{Y2} of the second magnetoresistance effect element 17 may be respectively deviated from the X1-X2 direction and the Y1-Y2 direction if in an orthogonal relationship with each other, but each of the positions can be appropriately detected if the X1-X2 direction and the Y1-Y2 direction are in the sensitivity axis directions P_{X2} and P_{Y2}, respectively.

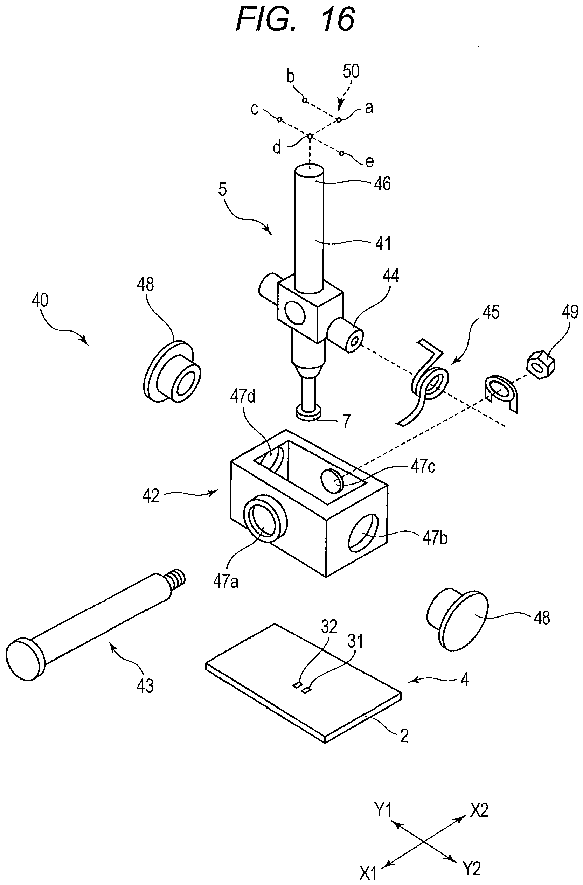

The magnetic detection type switch according to the embodiment is mounted on, for example, a shift lever device 40 shown in Fig. 16.

The shift lever device 40 is configured to include a shift lever (shaft) 41, a bearing 42, a substrate 2, a first shaft portion 43 that is connected to the shift lever 41 and extends in the X1-X2 direction, a second shaft portion 44 that extends in the Y1-Y2 direction, a home position return spring 45, and the like.

A shift knob 46 is disposed in an upper end portion of the shift lever 41 that is shown in Fig. 16. Part of the shift lever 41 is accommodated in a space in the bearing 42. Through-holes 47a to 47d are disposed in respective side surfaces of the bearing 42, and the first shaft portion 43 and the second shaft portion 44 that are connected to the shift lever 41 pass through the through-holes 47a to 47d. In a state where the second shaft portion 44 is accommodated toward the through-holes 47b and 47d from an inner portion of the bearing 42, a regulating member 48 is fitted from outer sides of the through-holes 47b and 47d. Also, in a state where the shift lever 41 is arranged in the bearing 42, the first shaft portion 43 passes from outside via the through-hole 47a, and is stopped from coming out by a screw 49 on the through-hole 47c side of the first shaft portion 43.

The shift lever 41 can be operated to be moved along a shift pattern regulating plate, which is not shown herein. Even when the shift lever 41 is operated to be moved along a shift pattern 50, the shift lever 41 is biased by the home position return spring 45 to return to a home position a when the hand is released.

The shift lever 41 can be moved to each of positions a to d along the shift pattern 50 by a supporting structure in which the first shaft portion 43 and the second shaft portion 44 that are connected to the shift lever 41, the bearing 42, and the like are assembled. The positions a to d of the shift lever 41 respectively correspond to the positions (1) to (5) which are shown in Fig. 5.

The shift lever 41 that is shown in Fig. 16 is equivalent to the movable portion 5, and the magnet 7 is attached to a tip of the movable portion 5. The first magnetic detection unit 31 and the second magnetic detection unit 32 are installed on the substrate 2.

When the shift lever 41 is at the home position a, the magnet 7 is at the first position (1) of Fig. 5. When the shift lever 41 is operated to be moved to the position b, the shift lever 41 is pivoted in the Y1-Y2 direction about the pivot axis of the X1-X2 direction, and the magnet 7 is moved to the second position (2) of Fig. 6. When the shift lever 41 is moved from the home position a to the position d, the shift lever 41 is pivoted in the X1-X2 direction about the pivot axis of the Y1-Y2 direction, and the magnet 7 is moved to the fourth position (4) of Fig. 8. When the shift lever 41 is moved to the position c from this state, the magnet 7 can be moved to the third position (3) of Fig. 7. When the shift lever 41 is moved to a position e, the magnet 7 can be moved to the fifth position (5) of Fig. 9.

Accordingly, each of the positions a to e of the shift lever 41 can be accurately detected by using the magnetic detection type switch of the embodiment. In particular, fault detection redundancy can be added, and driving safety can be improved.

## Claims

1. A magnetic detection type switch (30) in which a single magnetic field generation unit (7) is disposed in a movable portion (5) and two magnetic detection units (31, 32) are disposed in a fixed portion (2);
wherein each magnetic detection unit (31, 32) has two first magnetoresistance effect elements (11) and two second magnetoresistance effect elements (17) that have a structure in which a fixed magnetic layer (13) and a free magnetic layer (15) having a magnetization directing in a direction of an external magnetic field are laminated via a non-magnetic layer, and a first sensitivity axis direction (PX2) of the first magnetoresistance effect elements (11) and a second sensitivity axis direction (PY2) of the second magnetoresistance effect elements (17) are orthogonal to each other;
wherein each magnetic detection unit (31, 32) comprises a first bridge circuit (23) and a second bridge circuit (26), respectively, each first bridge circuit (23) comprising a first leg and a second leg connected in parallel with each other, each of the first and second legs comprising one of the first magnetoresistance effect elements (11) and a fixed resistance element (18) serially connected with each other at a midpoint of the respective leg, wherein the order of the first magnetoresistance effect element (11) and the fixed resistance element (18) in the second leg is reversed with respect to the first leg; and each second bridge circuit (26) comprising a third leg and a fourth leg connected in parallel with each other, each of the third and fourth legs comprising one of the second magnetoresistance effect elements (17) and a fixed resistance element (18) serially connected with each other at a midpoint of the respective leg, wherein the order of the second magnetoresistance effect element (17) and the fixed resistance element (18) in the fourth leg is reversed with respect to the third leg;
wherein the two midpoints of the legs of the first bridge circuit (23) are connected to a first differential amplifier (24), the output of which is connected to a first Schmitt trigger circuit (25) which is configured for outputting a first ON or OFF detection output (1-S1, 2-S1); and
wherein the two midpoints of the legs of the second bridge circuit (26) are connected to a second differential amplifier (27), the output of which is connected to a second Schmitt trigger circuit (28) which is configured for outputting a second ON or OFF detection output (1-S2, 2-S2);
wherein the movable portion (5) is supported to be movable between six positions ((1) to (6)) that are divided by two parallel first virtual lines (A) extending parallel to the first sensitivity axis direction (PX2) and a second virtual line (B) which is orthogonal to the first virtual lines (A) in a plane, wherein the first virtual lines (A) are disposed with a gap in the direction of the second virtual line (B) so that an inner portion of the plane is divided into the positions ((1) to (6)), the number of which is six;
wherein the magnetic detection units (31, 32) are fixedly supported at the crossing positions (C) of the first virtual lines (A) with the second virtual line (B),
wherein the movable portion (5) is supported to be movable between five or more of the positions among the six positions ((1) to (6)), and wherein the five or more of the positions ((1) to (6)) are detectable based on the first detection outputs (1-S1, 2-S1), which are obtained from the first bridge circuits (23) comprising the first magnetoresistance effect elements (11), and the second detection outputs (1-S2, 2-S2), which are obtained from the second bridge circuits (26) comprising the second magnetoresistance effect elements (17), in each of the magnetic detection units (31, 32); and
wherein, when any of the first detection outputs (1-S1, 2-S1) is out of order, five or more of the six positions ((1) to (6)) are detectable by activating a system, which is comprised in the magnetic detection type switch and which is configured for combining the three remaining detection outputs (1-S1, 1-S2, 2-S2 or 2-S1, 1-S2, 2-S2).

2. The magnetic detection type switch (30) according to Claim 1 ,
wherein the fixed magnetic layer (13) is a self-pin stop type in which a first magnetic layer (13(a)) and a second magnetic layer (13(c)) are laminated via a non-magnetic intermediate layer (13(b)), and the first magnetic layer (13(a)) and the second magnetic layer (13(c)) are magnetization-fixed in anti-parallel with each other.

3. A shift lever device (40) comprising:
the magnetic detection type switch (30) according to any one of claims 1 or 2; and
a shift lever (41);
wherein the movable portion (5) moves according to an inclination of the shift lever (41); and
wherein the fixed portion (2) faces the movable portion (5).

## Patentansprüche

1. Schalter (30) vom magnetischen Detektions-Typ (30), bei dem eine einzelne Magnetfelderzeugungseinheit (7) in einem beweglichen Bereich (5) angeordnet ist und zwei magnetische Detektionseinheiten (31, 32) in einem feststehenden Bereich (2) angeordnet sind,
wobei jede magnetische Detektionseinheit (31, 32) zwei erste Magnetowiderstandseffekt-Elemente (11) und zwei zweite Magnetowiderstandseffekt-Elemente (17) aufweist, die eine Struktur aufweisen, bei der eine fixierte magnetische Schicht (13) und eine freie magnetische Schicht (15) mit einer in Richtung eines externen Magnetfelds gerichteten Magnetisierung über eine nichtmagnetische Schicht zusammen laminiert sind und eine erste Empfindlichkeitsachsenrichtung (PX2) der ersten Magnetowiderstandseffekt-Elemente (11) und eine zweite Empfindlichkeitsachsenrichtung (PY2) der zweiten Magnetowiderstandseffekt-Elemente (17) orthogonal zueinander sind;
wobei jede magnetische Detektionseinheit (31, 32) eine erste Brückenschaltung (23) bzw. eine zweite Brückenschaltung (26) aufweist, wobei jede erste Brückenschaltung (23) einen ersten Schenkel und einen zweiten Schenkel aufweist, die einander parallel geschaltet sind, wobei bei jedem von dem ersten und zweiten Schenkel eines von den ersten Magnetowiderstandseffekt-Elementen (11) und ein feststehendes Widerstandselement (18) an einem Mittelpunkt des jeweiligen Schenkels miteinander in Reihe geschaltet sind, wobei die Reihenfolge des ersten Magnetowiderstandseffekt-Elements (11) und des feststehenden Widerstandselements (18) bei dem zweiten Schenkel umgekehrt zu der bei dem ersten Schenkel ist; und wobei jede zweite Brückenschaltung (26) einen dritten Schenkel und einen vierten Schenkel aufweist, die einander parallel geschaltet sind, wobei bei jedem von dem dritten und vierten Schenkel eines von den zweiten Magnetowiderstsandseffekt-Elementen (17) und ein feststehendes Widerstandselement (18) an einem Mittelpunkt des jeweiligen Schenkels miteinander in Reihe geschaltet sind, wobei die Reihenfolge des zweiten Magnetowiderstandseffektelements (17) und des feststehenden Widerstandselements (18) bei dem vierten Schenkel umgekehrt zu der bei dem dritten Schenkel ist;
wobei die beiden Mittelpunkte der Schenkel der ersten Brückenschaltung (23) mit einem ersten Differenzverstärker (24) verbunden sind, dessen Ausgang mit einer ersten Schmitt-Trigger-Schaltung (25) verbunden ist, die zum Abgeben eines ersten EIN- oder AUS-Detektions-Ausgangssignals (1-S1, 2-S1) ausgebildet ist; und
wobei die beiden Mittelpunkte der Schenkel der zweiten Brückenschaltung (26) mit einem zweiten Differenzverstärker (27) verbunden sind, dessen Ausgang mit einer zweiten Schmitt-Trigger-Schaltung (28) verbunden ist, die zum Abgeben eines zweiten EIN- oder AUS-Detektions-Ausgangssignals (1-S2, 2-S2) ausgebildet ist;
wobei der bewegliche Bereich (5) derart gelagert ist, dass er zwischen sechs Positionen ((1) bis (6)) beweglich ist, die durch zwei parallele erste virtuelle Linien (A), die sich parallel zu der ersten Empfindlichkeitsachsenrichtung (PX2) erstrecken, und eine zweite virtuelle Linie (B), die in einer Ebene orthogonal zu den ersten virtuellen Linien (A) ist, geteilt sind, wobei die ersten virtuellen Linien (A) mit einem Zwischenraum in Richtung der zweiten virtuellen Linie (B) angeordnet sind, so dass ein innerer Bereich der Ebene in die Positionen ((1) bis (6)) unterteilt ist, deren Anzahl sechs beträgt;
wobei die magnetischen Detektionseinheiten (31, 32) an den Kreuzungsstellen (C) der ersten virtuellen Linien (A) mit der zweiten virtuellen Linie (B) feststehend gelagert sind,
wobei der bewegliche Bereich (5) zwischen fünf oder mehr der Positionen von den sechs Positionen ((1) bis (6)) beweglich gelagert ist, und wobei die fünf oder mehr der Positionen ((1) bis (6)) auf der Basis der ersten Detektions-Ausgangssignale (1-S1, 2-S1), die von den die ersten Magnetowiderstandseffekt-Elemente (11) aufweisenden ersten Brückenschaltungen (23) ermittelt werden, sowie auf der Basis der zweiten Detektions-Ausgangssignale (1-S2, 2-S2), die von den die zweiten Magnetowiderstandseffekt-Elemente (17) aufweisenden zweiten Brückenschaltungen (26) ermittelt werden, in jeder der magnetischen Detektionseinheiten (31, 32) detektierbar sind; und
wobei dann, wenn irgendeiner der ersten Detektionsausgänge (1-S1, 2-S1) nicht funktioniert, fünf oder mehr der sechs Positionen ((1) bis (6)) durch Aktivieren eines Systems detektierbar sind, das in dem Schalter vom magnetischen Detektions-Typ enthalten ist und dazu ausgebildet ist, die drei verbleibenden Detektionsausgänge (1-S1, 1-S2, 2-S2 oder 2-S1, 1-S2, 2-S2) zu kombinieren.

2. Schalter (30) vom magnetischen Detektions-Typ (30) nach Anspruch 1, wobei es sich bei der fixierten magnetischen Schicht (13) um einen selbstgepinnten Stop-Typ handelt, bei dem eine erste magnetische Schicht (13(a)) und eine zweite magnetische Schicht (13(c)) über eine nichtmagnetische Zwischenschicht (13(b)) zusammen laminiert sind und die erste magnetische Schicht (13 (a)) und die zweite magnetische Schicht (13 (c)) anti-parallel zueinander Magnetisierungs-fixiert sind.

3. Schalthebelvorrichtung (40), aufweisend:
den Schalter (30) vom magnetischen Detektions-Typ (30) nach einem der Ansprüche 1 oder 2; und
einen Schalthebel (41);
wobei sich der bewegliche Bereich (5) in Abhängigkeit von einer Neigung des Schalthebels (41) bewegt; und
wobei der feststehende Bereich (2) dem beweglichen Bereich (5) zugewandt gegenüberliegt.

## Revendications

1. Commutateur de type de détection magnétique (30) dans lequel une seule unité de génération de champ magnétique (7) est disposée dans une partie mobile (5) et deux unités de détection magnétique (31, 32) sont disposées dans un partie fixe (2) ;
**caractérisé en ce que** chaque unité de détection magnétique (31, 32) possède deux premiers éléments à effet de magnétorésistance (11) et deux deuxièmes éléments à effet de magnétorésistance (17) qui possèdent une structure dans laquelle une couche magnétique fixe (13) et une couche magnétique libre (15) ayant une magnétisation dirigée dans le sens d'un champ magnétique externe sont stratifiées à l'aide d'une couche non magnétique, et où le sens d'un premier axe de sensibilité (PX2) des premiers éléments à effet de magnétorésistance (11) et le sens d'un deuxième axe de sensibilité (PY2) des deuxièmes éléments à effet de magnétorésistance (17) sont orthogonaux l'un par rapport à l'autre ;
où chaque unité de détection magnétique (31, 32) comprend un premier montage en pont (23) et un deuxième montage en pont (26), respectivement, chaque premier montage en pont (23) comprenant une première branche et une deuxième branche connectées en parallèle l'une à l'autre, chacune des première et deuxième branches comprenant l'un des premiers éléments à effet de magnétorésistance (11) et un élément de résistance fixe (18) connectés en série l'un à l'autre en un point médian de la branche respective, sachant que l'ordre du premier élément à effet de magnétorésistance (11) et de l'élément de résistance fixe (18) dans la deuxième branche est inversé par rapport à la première branche ; et chaque deuxième montage en pont (26) comprenant une troisième branche et une quatrième branche connectées en parallèle l'une à l'autre, chacune des troisième et quatrième branches comprenant l'un des deuxièmes éléments à effet de magnétorésistance (17) et un élément de résistance fixe (18) connectés en série l'un à l'autre en un point médian de la branche respective, sachant que l'ordre du deuxième élément à effet de magnétorésistance (17) et de l'élément de résistance fixe (18) dans la quatrième branche est inversé par rapport à la troisième branche ;
où les deux points médians des branches du premier montage en pont (23) sont connectés à un premier amplificateur différentiel (24), dont la sortie est connectée à une première bascule de Schmitt (25) qui est configurée de manière à produire une première sortie de détection ON ou OFF (1-S1, 2-S1) ; et
où les deux points médians des branches du deuxième montage en pont (26) sont connectés à un deuxième amplificateur différentiel (27), dont la sortie est connectée à une deuxième bascule de Schmitt (28) qui est configurée de manière à produire une deuxième sortie de détection ON ou OFF (1-S2, 2-S2) ;
où la partie mobile (5) est supportée de manière à pouvoir être déplacée entre six positions ((1) à (6)) qui sont divisées par deux premières lignes virtuelles (A) parallèles s'étendant parallèlement au sens du premier axe de sensibilité (PX2) et une deuxième ligne virtuelle (B) qui est orthogonale aux premières lignes virtuelles (A) sur un plan, sachant que les premières lignes virtuelles (A) sont disposées avec un écart dans le sens de la deuxième ligne virtuelle (B), de telle sorte qu'une partie intérieure du plan est divisée dans les différentes positions ((1) à (6)), au nombre de six ;
où les unités de détection magnétique (31, 32) sont supportées de manière fixe aux positions de croisement (C) des premières lignes virtuelles (A) avec la deuxième ligne virtuelle (B),
où la partie mobile (5) est supportée de manière à pouvoir être déplacée entre cinq ou plus des positions parmi les six positions ((1) à (6)), et où les cinq ou plus des positions ((1) à (6)) sont détectables sur la base des premières sorties de détection (1-S1, 2-S1), qui sont obtenues à partir des premiers montages en pont (23) comprenant les premiers éléments à effet de magnétorésistance (11), et des deuxièmes sorties de détection (1-S2, 2-S2), qui sont obtenues à partir des deuxièmes montages en pont (26) comprenant les deuxièmes éléments à effet de magnétorésistance (17), dans chacune des unités de détection magnétique (31, 32) ; et
où, lorsque l'une quelconque des premières sorties de détection (1-S1, 2-S1) est hors service, cinq ou plus des six positions ((1) à (6)) sont détectables en activant un système qui est compris dans le commutateur de type de détection magnétique et qui est configuré de manière à combiner les trois sorties de détection restantes (1-S1, 1-S2, 2-S2 ou 2-S1, 1-S2, 2-S2).

2. Le commutateur de type de détection magnétique (30) selon la revendication 1,
**caractérisé en ce que** la couche magnétique fixe (13) est un type d'arrêt à broche autonome dans lequel une première couche magnétique (13(a)) et une deuxième couche magnétique (13(c)) sont stratifiées à l'aide d'une couche intermédiaire non magnétique (13(b)), et la première couche magnétique (13(a)) et la deuxième couche magnétique (13(c)) sont fixées par magnétisation l'une à l'autre en antiparallèle.

3. Dispositif de levier de changement de vitesse (40) comprenant :
le commutateur de type de détection magnétique (30) selon l'une quelconque des revendications 1 ou 2 ; et
un levier de changement de vitesse (41) ;
où la partie mobile (5) se déplace selon une inclinaison du levier de vitesse (41) ; et
où la partie fixe (2) fait face à la partie mobile (5).
